(19) Europäisches Patentamt
European Patent Office
Office européen des brevets

(11) **EP 0 695 952 A1**

(12) **EUROPÄISCHE PATENTANMELDUNG**

(43) Veröffentlichungstag:
**07.02.1996 Patentblatt 1996/06**

(51) Int. Cl.⁶: **G01R 33/561**

(21) Anmeldenummer: **95202083.2**

(22) Anmeldetag: **31.07.1995**

(84) Benannte Vertragsstaaten:
**DE FR GB NL**

(30) Priorität: **03.08.1994 DE 4427430**

(71) Anmelder:
• **Philips Patentverwaltung GmbH**
**D-22335 Hamburg (DE)**
Benannte Vertragsstaaten:
**DE**

• **Philips Electronics N.V.**
**NL-5621 BA Eindhoven (NL)**
Benannte Vertragsstaaten:
**FR GB NL**

(72) Erfinder: **Schomberg, Hermann,**
**c/o Philips Patentverwalt.GmbH**
**D-22335 Hamburg (DE)**

(74) Vertreter: **Hartmann, Heinrich, Dipl.-Ing. et al**
**D-22335 Hamburg (DE)**

(54) **MR-Verfahren**

(57)    Die Erfindung betrifft ein MR-Verfahren zur Bestimmung der räumlichen Verteilung der Kernmagnetisierung in einem Untersuchungsbereich mit folgenden Schritten:

a) mindestens einmalige Anregung der Kernmagnetisierung in dem Untersuchungsbereich durch wenigstens einen Hochfrequenzimpuls in Anwesenheit eines stationären homogenen Magnetfeldes
b) Auslesen der nach der Anregung entstehenden MR-Signale zur Erzeugung von MR-Daten, wobei während des Auslesens auf den Untersuchungsbereich Gradienten-Magnetfelder einwirken
c) Variation dieser Gradienten-Magnetfelder derart, daß die MR-Signale im Ortsfrequenzbereich entlang wenigstens einer Spirale erfaßt werden, wobei in dem den niedrigen Ortsfrequenzen entsprechenden zentralen Teil des Ortsfrequenzbereiches die Spiralen bzw. deren Windungen eine höhere Dichte haben wie in dem übrigen Teil des Ortsfrequenzbereiches, und wobei die Spiralen im übrigen Teil des Ortsfrequenzbereiches zusammen mit ihren Spiegelbildern den übrigen Teil mit einer für die Rekonstruktion ausreichenden Dichte bedecken,
d) Rekonstruktion der Kernmagnetisierungsverteilung für den Untersuchungsbereich aus den MR-Daten.

Fig.3a

EP 0 695 952 A1

EP 0 695 952 A1

**Beschreibung**

Die Erfindung betrifft ein MR-Verfahren zur Bestimmung der Kernmagnetisierung eines Untersuchungsbereichs, bei dem die MR-Signale entlang spiralartiger Pfade im Ortsfrequenzbereich erfaßt werden (Spiral-MRI). Wie in der Veröffentlichung von Twieg "The k-trajectory formulation of the NMR imaging process ...", Med. Phys. 10 (5), Sep./Oct. 1983, pp 610-621 ausgeführt, wird ein MR-Signal im Ortsfrequenzbereich bzw. im sogenannten k-Raum längs eines Pfades erfaßt, dessen Verlauf von dem zeitlichen Verlauf der Gradienten-Magnetfelder abhängt, die nach der Anregung der Kernmagnetisierung in dem Untersuchungsbereich durch einen oder mehrere Hochfrequenzimpulse bis zur und während der Erfassung des MR-Signals wirksam sind. Der k-Raum ist zwei- oder dreidimensional - je nachdem, ob ein zwei- oder dreidimensionales MR-Untersuchungsverfahren benutzt wird. Die Erfassung des MR-Signals entlang spiralartiger Pfade hat den Vorteil einer vergleichsweise schnellen Erfassung der für die Rekonstruktion der Kernmagnetisierungsverteilung erforderlichen MR-Daten.

Aus der EP-OS 256 779 ist bereits ein MR-Verfahren bekannt, bei dem die MR-Signale entlang eines spiralartigen Pfades im Ortsfrequenzbereich abgetastet werden. Dabei besteht das Problem, daß infolge unterschiedlicher Relaxationszeiten $T_2$ die höheren Ortsfrequenzen, die dem Außenbereich des k-Raums entsprechen, je nach Gewebeart unterschiedlich erfaßt werden. Um dieses zu vermeiden, wird eine redundante Abtastung im k-Raum durchgeführt, wobei der spiralartige Pfad in der entgegengesetzten Richtung erneut abgetastet wird oder indem ein um eine halbe Windungsbreite versetzter spiralförmiger Pfad in der entgegengesetzten Richtung durchlaufen wird.

Durch diese redundante Abtastung wird die Untersuchungszeit und die Zahl der zu messenden MR-Daten vergrößert. Die Erfindung bezieht sich demgegenüber auf ein Verfahren, bei dem die Zahl der zu messenden MR-Daten ohne Verlust an räumlichem Auflösungsvermögen reduziert werden kann.

Aus dem Aufsatz von B. Ahn et al, "High-Speed Spiral-Scan Echo Planar NMR Imaging-I", IEEE Transactions On Medical Imaging, Vol. MI-5, No. 1, PP 2-7, 1986, ist ein solches Verfahren bekannt. Dabei wird das MR-Signal im k-Raum längs einer Spirale abgetastet, deren Windungen einen doppelt so großen Abstand voneinander haben, als für die Untersuchung eines Untersuchungsbereiches mit vorgegebener Größe und vorgegebenem räumlichen Auflösungsvermögen an sich erforderlich; dies führt zu einer Verkürzung der Meßzeit. Die fehlenden MR-Daten werden dabei durch MR-Hilfsdaten für Hilfspunkte im Ortsfrequenzbereich abgeleitet, die zwischen benachbarten Windungen der Spirale liegen. Zur Bestimmung der MR-Hilfsdaten werden die MR-Daten von Meßpunkten auf der Spirale herangezogen, die zu den Hilfspunkten symmetrisch bezüglich des Nullpunkts des Ortsfrequenzbereiches liegen. Dieses Verfahren kann allerdings nur dann zu einwandfreien Ergebnissen führen, wenn die Phase der MR-Daten Null ist. In der Praxis ist diese Forderung meist nicht erfüllt; die Phase kann dabei sogar eine leichte Ortsabhängigkeit aufweisen.

Aufgabe der vorliegenden Erfindung ist es, ein MR-Verfahren zu schaffen, bei dem die MR-Signale im Ortsfrequenzbereich entlang wenigstens eines spiralartigen Pfades ausgelesen werden, wobei ebenfalls nur ein Teil der für die Rekonstruktion erforderlichen MR-Daten gemessen wird und bei dem auch dann eine einwandfreie Rekonstruktion möglich ist, wenn die gemessenen MR-Daten mit einer Phase behaftet sind. Erfindungsgemäß wird diese Aufgabe durch folgende Schritte gelöst:

a) mindestens einmalige Anregung der Kernmagnetisierung in dem Untersuchungsbereich durch wenigstens einen Hochfrequenzimpuls in Anwesenheit eines stationären homogenen Magnetfeldes;

b) Auslesen der nach der Anregung entstehenden MR-Signale zur Erzeugung von MR-Daten, wobei während des Auslesens auf den Untersuchungsbereich Gradienten-Magnetfelder einwirken;

c) Variation dieser Gradienten-Magnetfelder derart, daß die MR-Signale im Ortsfrequenzbereich entlang wenigstens einer Spirale erfaßt werden, wobei in dem den niedrigen Ortsfrequenzen entsprechenden zentralen Teil des Ortsfrequenzbereiches die Spirale bzw. deren Windungen eine höhere Dichte haben als in dem übrigen Teil des Ortsfrequenzbereiches, und wobei die Spiralen im übrigen Teil des Ortsfrequenzbereiches zusammen mit ihren Spiegelbildern den übrigen Teil mit einer für die Rekonstruktion ausreichenden Dichte bedecken;

d) Rekonstruktion der Kernmagnetisierungsverteilung für den Untersuchungsbereich aus den MR-Daten.

Die Erfindung basiert auf folgenden Überlegungen:

Bei der Spiral-MRI ist die Größe des mit einer oder mehreren Spiralen bedeckten Ortsfrequenzbereiches durch die geforderte räumliche Auflösung vorgegeben. Bei vorgegebener Größe des Bereichs in dem die Kernmagnetisierungsverteilung bestimmt werden soll, ist dann auch der Abstand der Spiralen bzw. der Abstand einzelner Windungen einer Spirale voneinander vorgegeben. Die Erfindung beruht auf der Erkenntnis, daß sich die Dichte der Spiralen bzw. der Spiralwindungen in dem so vorgegebenen Spiralmuster außerhalb des zentralen Teils des Ortsfrequenzbereiches derart halbieren läßt, daß die Spirale(n) zusammen mit ihren Spiegelbildern gerade dieses Spiralmuster ergeben.

Als Spiegelbild einer Spirale wird eine Kurve bezeichnet, bei der sämtliche Kurvenpunkte spiegelbildlich zu den Punkten dieser Spirale liegen, wobei unter spiegelbildlich liegenden Punkten zwei Punkte verstanden werden, die vom Nullpunkt des Ortsfrequenzbereichs den gleichen Abstand haben und durch eine durch den Nullpunkt verlaufende Gerade miteinander verbunden werden können.

2

Wenn die halbierte Zahl von Spiralen zusammen mit ihren Spiegelbildern dem erwähnten Spiralmuster entspricht, kann die Kernmagnetisierungsverteilung mit dem vollen Auflösungsvermögen trotz der verringerten Zahl von Spiralen und einer entsprechend verminderten Zahl von auf den Spiralen gemessenen MR-Daten rekonstruiert werden. Allerdings verringert sich dabei das Signal/Rauschverhältnis.

Während die Dichte der Spiralen bzw. der Spiralwindungen im Vergleich zu dem für eine vollständige Rekonstruktion erforderlichen Spiralmuster reduziert ist, ist dies in dem zentralen Teil des Ortsfrequenzbereichs nicht der Fall. Unter Ausnutzung der Tatsache, daß sich die Phase der ermittelten Kernmagnetisierungsverteilung in der Regel nur relativ wenig als Funktion des Ortes ändert, kann dennoch eine vollständige Rekonstruktion der Kernmagnetisierungsverteilun erfolgen.

Es sei an dieser Stelle erwähnt, daß aus einer Veröffentlichung von S. Tadjudin et al "Partial K-Space Reconstruction for Spiral-Acquisition Imaging", Supplement to JMRI, Vol. 2 (P), p. S25, 1992 ein Verfahren bekannt ist, bei dem der Abstand der Spiralen für die höheren Ortsfrequenzen vergrößert ist, indem jede zweite Spirallinie weggelassen ist. Der im Zentrum liegende Niederfrequenzbereich wird gleichwohl ausreichend abgetastet. Die im höheren Ortsfrequenzbereich fehlenden MR-Daten werden aus den konjugiert komplexen Daten abgeleitet, die für die gleiche Ortsfrequenz - aber mit negativem Vorzeichen - gemessen wurden. Im übrigen enthält die Veröffentlichung hierzu keine näheren Angaben.

Eine erste Weiterbildung der Erfindung sieht vor, daß die Anregung der Kernmagnetisierung und das Auslesen der MR-Signale p/2 mal wiederholt werden, wobei p eine gerade Zahl ist, und daß der zeitliche Verlauf der GradientenMagnetfelder von Wiederholung zu Wiederholung so variiert wird,

a) daß sich p gleiche Spiralen mit um 360°/p gegeneinander versetzten Startwinkeln ergeben, die sich von dem Rand des zentralen Teils des Ortsfrequenzbereiches bis in dessen Zentrum erstrecken,
b) daß eine Gruppe von p/2 Spiralen, die so gewählt ist, daß die Differenz der Startwinkel zweier Spiralen dieser Gruppe stets verschieden von 180° ist, sich über den Rand des zentralen Teils hinaus erstreckt,
c) und daß nach einer Anregung eine Spirale dieser Gruppe und eine Spirale mit demgegenüber um 180° versetztem Startwinkel durchlaufen werden.

Weil hierbei nach einer Anregung der Kernmagnetisierung durch einen oder mehrere Hochfrequenzimpulse im zentralen Teil des Ortsfrequenzbereichs zunächst ein Spiralarm und dann die dazu spiegelbildliche Spirale, die sich über den zentralen Teil hinaus fortsetzt in dieser (oder der umgekehrten) Reihenfolge durchlaufen werden, sind nur p/2 Anregungen erforderlich, so daß sich die insgesamt zur Erfassung der MR-Daten benötigte Zeit halbiert.

Eine andere Weiterbildung der Erfindung sieht vor, daß die Gradienten-Magnetfelder so variiert werden, daß die daraus im Ortsfrequenzbereich entstehenden Spiralen sich über den zentralen Teil hinaus fortsetzen, wobei deren Steigung außerhalb des zentralen Teiles doppelt so groß ist wie innerhalb des zentralen Teiles. Im Gegensatz zu der vorgenannten Weiterbildung ist die Zahl der Spiralen im zentralen Teil des Ortsfrequenzbereichs nicht größer als in dem übrigen Teil des Ortsfrequenzbereichs, jedoch ist der Abstand benachbarter Spiralen bzw. benachbarter Spiralwindungen im zentralen Teil nur halb so groß wie außerhalb, weil ihre Steigung (d.h. die Zunahme des Abstandes vom Nullpunkt pro Windung) nur halb so groß ist.

Eine Weiterbildung der Erfindung sieht vor, daß die Spirale(n) jeweils durch mehrere aufeinanderfolgende Anregungs- und Auslesezyklen durchlaufen werden. Hierdurch wird (werden) die Spirale(n) in mehrere Abschnitte zerlegt, wodurch sich der schädliche Einfluß der Kernmagnetisierungsverteilung gleichmäßig über den abgetasteten Ortsfrequenzbereich verteilt.

Die Erfindung eignet sich nicht nur zur Ermittlung der Kernmagnetisierungsverteilung in einem zweidimensionalen - insbesondere ebenen - Bereich, sondern auch zur dreidimensionalen Bestimmung der Kernmagnetisierungsverteilung. Dies setzt voraus, daß die MR-Signale in einem dreidimensionalen Ortsfrequenzbereich erfaßt werden. Dieser kann aus einer Anzahl zueinander paralleler oder sich in einer durch den Ortsfrequenz-Nullpunkt verlaufenden Geraden schneidenden Schichten bzw. Ebenen zusammengesetzt werden, die jeweils eine oder mehrere Spiralen enthalten, oder aber aus einer Schar von koaxialen Kegelmänteln mit unterschiedlichen Öffnungswinkeln, deren Spitze im Nullpunkt des k-Raumes liegt und auf denen sich jeweils eine oder mehrere Spiralen befinden. Unter "Spirale" sind somit nicht nur ebene, zweidimensionale Kurvem zu verstehen.

Eine MR-Anordnung zur Durchführung des erfindungsgemäßen Verfahrens ist versehen mit:

a) einem Magneten zur Erzeugung eines stationären, homogenen Magnetfeldes im Untersuchungsbereich,
b) einer Hochfrequenzspulen-Anordnung zum Senden von magnetischen Hochfrequenzimpulsen bzw. zum Empfangen von MR-Signalen,
c) Gradientenspulen-Anordnungen zur Erzeugung von in Richtung des stationären homogenen Magnetfeldes verlaufenden Gradienten-Magnetfeldern mit in drei zueinander senkrechten Richtungen verlaufenden Gradienten,
d) einem Empfänger zum Umsetzen der MR-Signale in eine Folge digitaler MR-Daten,

e) einer Rekonstruktionseinheit zur Rekonstruktion der Kernmagnetisierungsverteilung im Untersuchungsbereich aus den MR-Daten

f) einer Steuereinheit zur Steuerung der Einheiten a) bis e), die den zeitlichen Verlauf der Ströme durch die Gradientenspulen-Anordnungen derart steuert, daß die MR-Signale im Ortsfrequenzbereich entlang wenigstens einer Spirale erfaßt werden, wobei in dem den niedrigen Ortsfrequenzen entsprechenden zentralen Teil des Ortsfrequenzbereiches die Spiralen bzw. deren Windungen eine mindestens doppelt so große Dichte haben wie in dem übrigen Teil des Ortsfrequenzbereiches, und wobei die Spiralen im übrigen Teil des Ortsfrequenzbereiches zusammen mit ihren Spiegelbildern den übrigen Teil mit einer für die Rekonstruktion ausreichenden Dichte bedecken.

Die Erfindung wird nachstehend anhand der Zeichnungen näher erläutert. Es zeigen:

Fig. 1      Eine Anordnung zur Durchführung des erfindungsgemäßen Verfahrens,
Fig. 2a     die Lage der Spiralen im k-Raum für eine konventionelle MR-Untersuchung,
Fig. 2b     ein dazu äquivalentes r,$\phi$-Diagramm,
Fig. 3a     die Lage der Spiralen im k-Raum bei einer ersten Ausführungsform der Erfindung,
Fig. 3b     das zugehörige r,$\phi$-Diagramm,
Fig. 4      ein Fluß-Diagramm zur Erläuterung des erfindungsgemäßen Verfahrens,
Fig. 5 a    die Lage der Spiralen im k-Raum für eine zweite Ausführungsform der Erfindung,
Fig. 5b     das zugehörige r,$\phi$-Diagramm und
Fig. 6      die Abtastebenen im k-Raum bei einer für die dreidimensionale Datenerfassung geeigneten Ausführungsform.

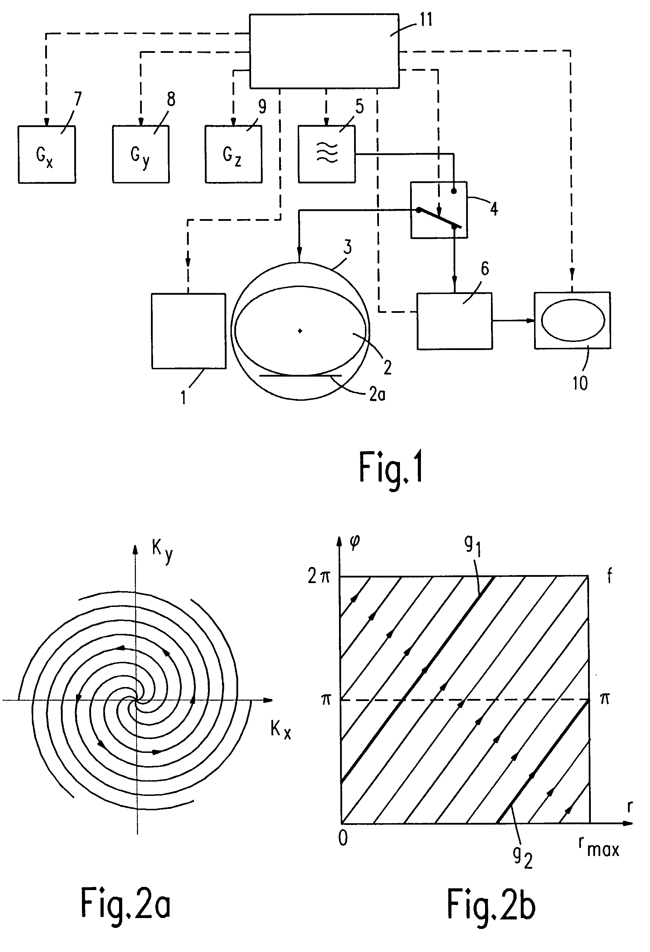

Fig. 1 zeigt einen schematisch dargestellten Magneten 1 zur Erzeugung eines stationären homogenen Magnetfeldes in einem Untersuchungsbereich. In dem Untersuchungsbereich befindet sich ein zu untersuchender Patient 2 auf einer Tischplatte 2a. Außer dem stationären Magnetfeld wirkt auf den Untersuchungsbereich ein hochfrequentes Magnetfeld ein, das impulsweise von einer Hochfrequenzspule 3 erzeugt wird.

Während der Erzeugung dieser magnetischen Hochfrequenzimpulse ist die Hochfrequenzspule 3 über einen Schalter 4 mit einem Hochfrequenzgenerator 5 verbunden. Die danach im Untersuchungsbereich auftretenden MR-Signale können mit der gleichen Hochfrequenzspule 3 empfangen werden. In diesem Fall ist die Hochfrequenzspule 3 über den Schalter 4 mit einem MR-Empfänger 6 verbunden.

Anstelle einer einzigen Hochfrequenzspule zum Erzeugen der Hochfrequenzimpulse und zum Empfangen der MR-Signale sowie anstelle des Schalters 4, der diese Hochfrequenzspule wahlweise mit dem Hochfrequenzgenerator 5 oder dem MR-Empfänger 6 verbindet, können auch getrennte Hochfrequenzspulen für die Erzeugung der Hochfrequenzimpulse einerseits und das Empfangen der MR-Signale andererseits benutzt werden.

Auf den Untersuchungsbereich wirken darüberhinaus noch Gradienten-Magnetfelder ein, die mit Hilfe von Gradientenspulenanordnungen 7, 8 und 9 erzeugt werden. Die Gradienten-Magnetfelder verlaufen in derselben Richtung wie das von dem Magneten 1 erzeugte homogene, stationäre Magnetfeld, jedoch haben diese Magnetfelder einen Gradienten. Die Gradienten der von den Gradientenspulen- anordnungen 7, 8, 9 erzeugten Magnetfelder stehen zueinander senkrecht.

In dem Empfänger 6 werden die MR-Signale, die die Modulation eines hochfrequenten Trägers bilden, demoduliert und digitalisiert. Aus den so gebildeten MR-Daten wird in dem Empfänger 6 ein Bild der Kernmagnetisierungsverteilung im Untersuchungsbereich rekonstruiert, das mittels eines Monitors 10 wiedergegeben werden kann. Das zeitliche Zusammenwirken der Einheiten 3...10 wird von einer vorzugsweise programmierbaren Steuereinheit 11 gesteuert.

Wenn die Steuereinheit 11 während des Empfangs der zur Rekonstruktion herangezogenen MR-Signale den zeitlichen Verlauf zweier Gradienten-Magnetfelder, z.B. der von den Gradientenspulenanordnungen 7 und 8 erzeugten Gradienten-Magnetfelder $G_x$ und $G_y$ in geeigneter Weise zeitlich sinusähnlich verändert und dabei deren Amplituden zu oder abnehmen läßt, werden die MR-Signale im zweidimensionalen k-Raum längs spiralförmiger Pfade abgetastet.

Fig. 2a zeigt das dabei resultierende Spiralmuster im k-Raum. Das Spiralmuster setzt sich aus p (=6) Spiralen zusammen, die jeweils die Form einer archimedischen Spirale haben. Der (zeitliche) Verlauf einer Spirale genügt also den Gleichungen:

$$k_x(t) = a \, |t| \cos(\omega t + \alpha) \qquad (1)$$

und

$$k_y(t) = a \, |t| \sin(\omega t + \alpha) \qquad (2)$$

a ist dabei die Steigung einer Spirale, die den Abstand zwischen benachbarten Windungen angibt, $\omega$ die Winkelgeschwindigkeit mit der sich der k-Vektor im k-Raum bewegt, und $\alpha$ bezeichnet den Startwinkel, d.h. den Winkel mit der $k_x$-Achse, unter dem die Spirale im Nullpunkt des k-Raums startet. t ist ein Parameter, vorzugsweise die Zeit . Die Startwinkel sind gleichmäßig verteilt, so daß sich die Beziehung ergibt:

$$\alpha = \alpha_o + 2n\pi/p \; ;n =1.......p \qquad (3)$$

Allen MR-Daten, die während der beschriebenen MR-Untersuchung erfaßt werden, lassen sich im k-Raum Punkte zuordnen, die gleichmäßig verteilt über die p Spiralen sind. Auf einer einzigen Spirale befinden sich die MR-Daten, die nach einer Anregung der Kernmagnetisierung in dem Untersuchungsbereich ausgelesen werden. Um das in Fig. 2a dargestellte Spiralmuster mit seinen p Spiralen zu erzeugen, sind also p Sequenzen erforderlich, die jeweils die Anregung des Untersuchungsbereichs durch einen oder mehrere0 Hochfrequenzimpulse und das anschließende Auslesen der MR-Signale bei entsprechendem zeitlichen Verlauf der Gradienten-Magnetfelder $G_x$, $G_y$ umfassen.

Für den Zusammenhang zwischen dem Vektor G (= $G_x$, $G_y$) der magnetischen Gradienten-Magnetfelder und dem Vektor k (= $k_x$,$k_y$) im Ortsfrequenzbereich gilt bekanntlich die Beziehung:

$$(4)$$

$$G_x = \frac{1}{\gamma}\frac{dk_x}{dt} \qquad und \qquad G_y = \frac{1}{\gamma}\frac{dk_y}{dt}$$

Dabei ist $\gamma/2\pi$ die gyromagnetische Konstante (42,6 MHz/T für Wasserstoff) und $k_x$ bzw $k_y$ haben den durch Gleichung (1) und (2) vorgegebenen zeitlichen Verlauf. Der sich hieraus ergebende zeitliche Verlauf der Gradienten-Magnetfelder und dessen Integration in eine MR-Sequenz sind u.a. in dem eingangs erwähnten Artikel von C.B. Ahn et al., insbesondere dessen Fig. 1 dargestellt, worauf an dieser Stelle ausdrücklich bezug genommen wird.

Fig. 2b zeigt ein zu der Darstellung von Fig. 2a äquivalentes Diagramm, das die Polar-Koordinaten r,$\phi$ der Spiralen im k-Raum darstellt. Bei einer archimedischen Spirale besteht zwischen dem Winkel $\phi$, den ein einen Punkt auf dieser Spirale mit dem Nullpunkt des k-Raums verbindender Strahl mit der $k_x$-Achse einschließt, und der Länge r dieses Strahls ein linearer Zusammenhang, so daß jede Spirale im k-Raum in eine Gerade im r,$\phi$-Diagramm übergeht. Weil r($2\pi$) dem Wert r(0) entspricht, ergibt sich bei $\phi=2\pi$ in diesen Geraden ein Sprung ein sägezahnartiger Sprung. So gehören beispielsweise die fett gezeichneten Geraden-Stücke G1 und G2 zu einer einzigen Spirale im Diagramm der Fig. 2a. Die p identischen Spiralen mit gleichmäßig verteilten Startwinkeln gehen in dem r,$\phi$-Diagramm der Fig. 2b über in p parallele Geraden, die in $\phi$-Richtung jeweils um den gleichen Betrag gegeneinander versetzt sind.

Die Zahl p der Spiralen (im Beispiel 6), die Zahl der Windungen jeder einzelnen Spirale (im Beispiel 4/3-Windungen) sowie der Abstand der Spiralen voneinander bestimmen in dem aus dem MR-Daten rekonstruierten MR-Bild das räumliche Auflösungsvermögen und die Größe des abgebildeten Bereiches. Will man beispielsweise die Kernmagnetisierung in einem Bereich von N x N Bildpunkten rekonstruieren, dann muß das Produkt aus der Zahl p der Spiralen und der Zahl der Windungen dem Wert N entsprechen und auf jeder Windung einer Spiralarme müssen $\pi N/2$ MR-Daten erfaßt werden. Bei einer Größe der Bildpunkte von d muß der Radius des mit dem Spiralmuster belegten k-Raumes $\pi/d$ betragen. Für den Faktor a (siehe Gleichung 1) ergibt sich dann $a=2\pi p/(dN)$, und für $\omega$ gilt dann $\omega = \pi N/(pT)$, wobei T die Meßzeit pro Spirale ist.

Daraus ergibt sich, daß die Zahl der Spiralen bzw. die Windungszahl jeder einzelnen Spirale um so größer ist, je mehr Bildpunkte ein MR-Bild des Untersuchungsbereichs umfassen soll. Die Untersuchungsdauer, die erforderlich ist, um die für die Rekonstruktion der Kernmagneti- sierungsverteilung erforderlichen MR-Daten zu erfassen, steigt aber mit der Zahl der Spiralen, während der Einfluß von Inhomogenitäten des von dem Magneten 1 erzeugten stationären Magnetfeldes auf die Bildqualität mit der Windungszahl bzw. der Meßzeit T pro Spirale zunimmt. Die Erfindung soll daher Wege zeigen, wie man auch mit weniger Spiralen bzw. mit verkürzten Spiralen ein MR-Bild rekonstruieren kann, ohne das räumliche Auflösungsvermögen des MR-Bildes oder die Zahl der Bildelemente, aus denen es sich zusammensetzt, zu verringern. Dazu werden bei dem im folgenden erläuterten erfindungsgemäßen Verfahren folgende Sachverhalte ausgenutzt:

a) Zwei Spiralen mit derselben Steigung a, aber um $\pi$ bzw. 180° versetztem Startwinkel, verlaufen spiegelbildlich zueinander bzw. es gilt:

$$k(t) = - k(t + \frac{\pi}{\omega}) \; ; k = k_x \; bzw \; k_y \qquad (5)$$

b) Im Idealfall sind die MR-Daten, die zwei im k-Raum spiegelbildlich zueinander liegenden Meßpunkten zugeordnet sind zueinander konjugiert komplex. In der Praxis ergeben sich jedoch infolge von Phasendrehungen Abweichungen von diesem idealen Verhalten. Diese Phasendrehung ändert sich jedoch in der Regel nur geringfügig innerhalb des MR-Bildes, so daß für die höheren Ortsfrequenzkomponenten eines solchen Bildes von einer konstanten Phasendrehung ausgegangen werden kann.

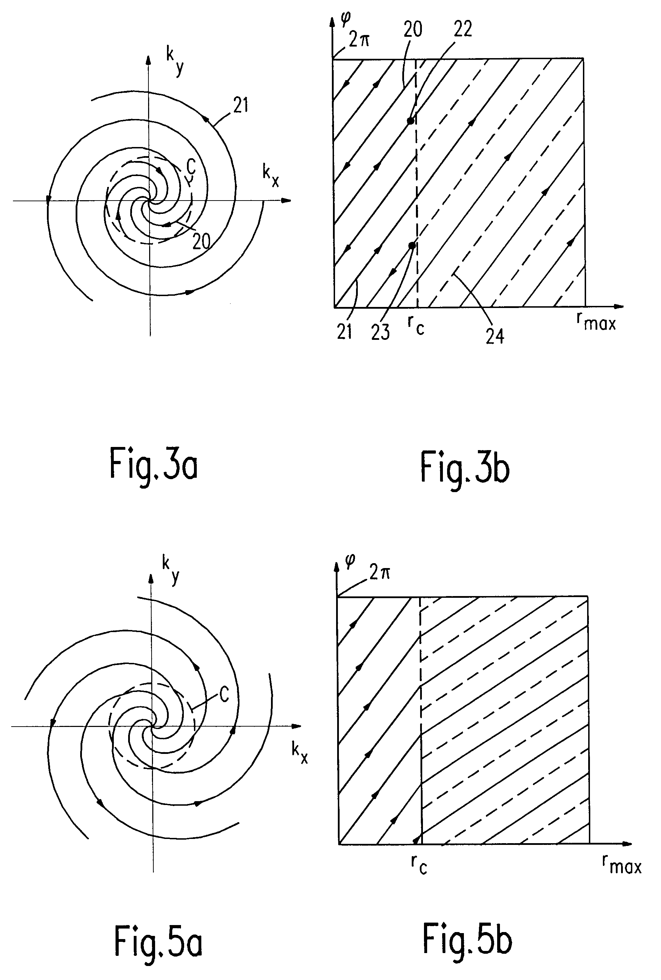

Wenn es gemäß Bedingung b) also möglich ist, die MR-Daten für (Hilfs-) Punkte im MR-Raum aus den gemessenen MR-Daten abzuleiten, die bestimmten Punkten im k-Raum zugeordnet sind, dann ist es nicht erforderlich, für sämtliche Punkte des in Fig. 2a dargestellten Spiralmusters Meßwerte zu erfassen, weil wenigstens ein Teil der Meßwerte aus den gemessenen MR-Daten abgeleitet werden kann. Dies wird im folgenden anhand der Figuren 3a und 3b näher erläutert.

Die Spiralen im k-Raum gemäß Fig. 3a stellen die Pfade dar, längs derer die MR-Signale bei einer MR-Untersuchung abgetastet werden. Innerhalb des den niedrigen Ortsfrequenzen entsprechenden Kreises C um den Nullpunkt des Ortsfrequenzbereiches ist die Zahl und die Lage der Spiralen identisch mit Fig. 2a. Außerhalb dieses Kreises fehlt jedoch jede zweite Spirale. In dem zugehörigen r,ϕ-Diagramm, in dem der Radius des Kreises mit $r_c$ bezeichnet ist, sind die weggelassenen Spiralen (für $r>r_c$) durch gestrichelte Linien angedeutet. Da außerhalb des Kreises C die Hälfte der Spiralen fehlt, ist die Zahl der zur Rekonstruktion zur Verfügung stehenden gemessenen MR-Daten geringer als bei dem Spiralmuster nach Fig. 2a. Trotzdem läßt sich aus diesem reduzierten Datensatz ein MR-Bild von einem genauso großen Teil des Untersuchungsbereiches mit dem gleichen räumlichen Auflösungsvermögen herstellen, wie bei Fig. 2a (allerdings ist das Signal/Rauschverhältnis verschlechtert).

Die Reduktion der MR-Daten ist allerdings erst dann von Vorteil, wenn entweder die Zahl der Spiralen insgesamt oder die zur Erfassung der auf einer Spirale liegenden MR-Daten benötigte Zeit verringert werden kann. Die einzelnen Spiralen sind in dem Diagramm der Fig. 3a aber nicht kürzer als bei Fig. 2a und die Zahl der Spiralen ist - zumindest innerhalb des Kreises C - nicht kleiner als bei Fig.2a. Um zu einer verringerten Meßzeit zu gelangen, werden während des Auslesens die Gradienten-Magnetfelder so variiert, daß im k-Raum zunächst ein vom Rand des Kreises zu dessen Zentrum verlaufender Spiralarm, z.B. der Spiralarm 20, durchlaufen wird und anschließend eine Spirale mit demgegenüber um 180° versetzten Startwinkel - das ist die Spirale 21. Zwar springt dabei der Startwinkel um 180°; da im Zentrum des Ortsfrequenzbereiches das zeitliche Integral über die Gradienten-Magnetfelder gerade den Wert Null erreicht hat, bedeutet dies keine sprunghafte Änderung der magnetischen Gradientenfelder. Somit kann der aus Fig. 3 ersichtliche reduzierte Datensatz mit p/2 (=3) Anregungen erfaßt werden, was die Untersuchungszeit nahezu halbiert.

Im folgenden wird anhand des in Fig. 4 dargestellten Flußdiagramms erläutert, wie aus dem reduzierten Datensatz gemäß Fig. 3a und Fig. 3b die Kernmagnetisierungsverteilung rekonstruiert wird:
Nachdem die MR-Daten $S_{lo}(k)$, die dem Zentrum des Ortsfrequenzbereichs - d.h. den niedrigeren Ortsfrequenzen - zugeordnet sind, vollständig und die MR-Daten $S_{hi}(k)$ zur Hälfte (gemäß Fig. 3b) erfaßt worden sind (Block 100), wird zunächst die Phasendrehung der hochfrequenten Ortsfrequenzen errechnet, die sich bei der Erfassung der MR-Daten ergeben hat. Wenn keine Phasendrehung vorläge, müßten die MR-Daten, die zueinander spiegelbildlich liegenden Punkten im k-Raum zugeordnet sind, zueinander konjugiert komplex sein. Wenn eine Phasendrehung β vorliegt, errechnet sie sich im Block 101 aus der Gleichung:

$$e^{2i\beta} = \frac{S^{*}_{lo}(k)}{S_{lo}(-k)} ; \qquad k = (k_x, k_y) \qquad (6)$$

Dabei ist $S^{*}_{lo}(k)$ ein MR-Datum, d.h. ein digitalisierter Wert, das konjugiert komplex zu dem für den Punkt $k(= k_x,k_y)$ im k-Raum gemessenen Abtastwert $S_{lo}(k)$ des MR-Signals ist. Mit $S_{lo}(-k)$ wird ein Meßwert bezeichnet, der einem dazu spiegelbildlichen Punkt zugeordnet ist. k sollte am Rande des Kreises C liegen.

In Fig. 3 b sind zwei im Kreis C spiegelbildlich zueinander liegende Punkte mit 22 und 23 bezeichnet. Sie haben den gleichen Radius (d.h. den gleichen Abstand vom Nullpunkt des k-Raums) und sie schließen mit der $k_x$-Achse um 180° bzw. π verschiedene Winkel ein. Um statistische Schwankungen zu vermeiden, ist es zweckmäßig, die entsprechenden Werte für mehrere zueinander spiegelbildlich liegende Punktpaare zu bilden und davon den Mittelwert zu errechnen.

Im nächsten Schritt (Block 102) werden für die höheren Ortsfrequenzen aus den gemessenen MR-Daten $S_{hi}(k)$ MR-Hilfsdaten $S'_{hi}$ errechnet gemäß der Gleichung:

$$S'_{hi}(-k) = e^{2i\beta} S^{*}_{hi}(k) \qquad (7)$$

Die Daten $S^*_{hi}(k)$ sind dabei konjugiert komplex zu den MR-Daten, die auf einer der Spiralen (z.B.21) außerhalb des Kreises C liegen. Die Daten $S'_{hi}(-k)$ sind den in Fig. 3a nicht dargestellten und in Fig. 3b gestrichelt angedeuteten Spiralen zugeordnet, die spiegelbildlich zu der betreffenden Spirale liegen. In Fig. 3b sind dies die (gestrichelt angedeuteten) Spiralen, die gegenüber der Ausgangsspirale um die Strecke $\pi$ nach oben oder nach unten versetzt sind. Zu der Spirale 21 liegt beispielsweise die Spirale 24 spiegelbildlich. Dabei wird die Bedingung a), bzw. die Gleichung 4 ausgenutzt.

Nachdem auf diese Weise für die außerhalb des Kreises weggefallenen Spiralen MR-Hilfsdaten $S'_{hi}(-k)$ aus den MR-Daten $S_{hi}(k)$ abgeleitet worden sind, die für dazu spiegelbildlich liegende Spiralen gemessen wurden, steht ein vollständiger Datensatz zur Verfügung, aus dem die Kernmagnetisierungsverteilung rekonstruiert werden kann. Dementsprechend erfolgt die Rekonstruktion der Kernmagnetisierungsverteilung s(x,y) im Block 103 nach der Gleichung:

$$s(x,y) = F^{-1}[S_{lo}(k_x,k_y) + S_{hi}(k_x,k_y) + S'_{hi}(-k_x,-k_y)] \tag{8}$$

Dabei stellt $F^{-1}[]$ die inverse Fouriertransformation über das Argument [] dar. Diese wird zweckmäßigerweise entsprechend dem "Gridding-Algorithmus" ausgeführt, der in einem Aufsatz von J.D.O.'Sullivan in der Zeitschrift IEEE Transactions on Medical Imaging, Vol.MI-4, no. 4, pp. 200-207, 1985 beschrieben ist.

Bei dem anhand von Fig. 3a erläuterten Ausführungsbeispiel wurde davon ausgegangen, daß gegenüber dem vollständigen Spiralmuster außerhalb des Kreises C jede zweite Spirale entfallen ist. Es ist aber nicht erforderlich, daß jede zweite Spirale entfällt. Bei p Spiralen können auch die p/2 ersten oder letzten Spiralen entfallen. Wesentlich ist nur, daß eine Gruppe von p/2-Spiralen verbleibt, die so gewählt ist, daß die Differenz der Startwinkel $\alpha$ zweier Spiralen dieser Gruppe stets verschieden von 180° bzw. $\pi$ ist.

Bei der Rekonstruktion gemäß dem in Fig. 4 dargestellten Flußdiagramm wurde davon ausgegangen, daß die Daten auf einer gegenüber Fig. 2a weggelassenen Spirale aus den MR-Daten einer dazu spiegelbildlich liegenden Spirale gemäß Gleichung 7 berechnet werden müssen. Dies ist nicht in jedem Fall erforderlich. Es ist auch möglich, diese Hilfsdaten sämtlich Null zu setzen und eine Rekonstruktion durchzuführen. Man erhält nach einigen weiteren Rechenschritten einen komplexen Datensatz s'(x,y), dessen Realteil die gewünschte MR-Verteilung s(x,y) wiedergibt.

Dem anhand von Fig 3a erläuterten Ausführungsbeispiel lag ein Spiralmuster mit einer geraden Anzahl p von Spiralen zugrunde. Demgegenüber stellen die Fig. 5a, 5b eine Möglichkeit dar, wie man bei einer ungeraden Zahl von Spiralen (p=5) einen reduzierten MR-Datensatz gewinnen kann, aus dem sich die Kernmagnetisierungsverteilung vollständig rekonstruieren läßt. Auch hier entspricht die Zahl und der Verlauf der Spiralen in dem den niedrigen Ortsfrequenzen entsprechenden Kreis C der Fig. 2a. Außerhalb des Kreises bleibt die Zahl der Spiralen zwar erhalten, jedoch wird dort ihre Steigung, d.h. der Wert a in den Gleichung (1) und (2), verdoppelt. Die maximalen Ortsfrequenzen werden daher mit weniger Spiralwindungen erreicht als bei dem vollständigen MR-Datensatz nach Fig. 2a, d.h. die Spiralen werden kürzer. Dadurch nimmt die Zahl bzw. die Dichte der auf den Spiralen außerhalb des Kreises C liegenden Daten ab.

Der zugehörige Verlauf im $r,\phi$-Diagramm ergibt sich aus Fig. 5b. Die Komplettierung dieses MR-Datensatzes und die Rekonstruktion der Kernmagnetisierung aus dem komplettierten Datensatz kann in ähnlicher Weise erfolgen wie in Fig. 4 für das Ausführungsbeispiel nach Fig. 3a erläutert. Es wird also zunächst wiederum der Phasenwinkel $\beta$ gemäß Gleichung 6 bestimmt (Block 101), wonach der k-Raum außerhalb des Kreises C um den Nullpunkt des Ortsfrequenzbereichs durch MR-Hilfsdaten $S'_{hi}(-k)$ ergänzt wird, die aus den gemessenen MR-Daten abgeleitet werden, die auf den gemessenen Spiralen liegen (Block 102). Die MR-Hilfsdaten $S'_{hi}(-k)$ sind den in Fig. 5a nicht dargestellten und in Fig. 5b gestrichelt angedeuteten Spiralen zugeordnet, die spiegelbildlich zu der betreffenden Spirale liegen.

Nachdem auf diese Weise der unvollständige Datensatz komplettiert ist, erfolgt gemäß Gleichung 8 (Block 103) eine inverse Fouriertransformation.

Bei dem anhand von Fig. 5a beschriebenen Verfahren zur Reduzierung des MR-Datensatzes ist die Zahl der Spiralen im Vergleich zu Fig. 2a nicht verringert, wohl aber die Länge der einzelnen Spiralen. Dies hat den Vorteil, daß der Zeitraum zwischen der Anregung der Kernmagnetisierung im Untersuchungsbereich durch einen oder mehrere Hochfrequenzimpulse und dem Ende des Ausleseintervalls verkürzt werden kann. Die dabei gewonnenen MR-Daten sind dann durch die Inhomogenitäten des Magnetfeldes weniger gestört, als wenn die MR-Daten vollständig gemäß Fig. 2a erfaßt werden.

Bei dem anhand von Fig 5b erläuterten Verfahren weisen die Spiralen für $r = r_c$ eine Knick auf. In der Praxis wird man diesen Knick abrunden; die zugehörigen Gradientenverläufe lassen sich bei vorgegeben Verlauf von k(t) gemäß Gleichung (4) berechnen.

Bei den vorangegangenen Ausführungsbeispielen wurde davon ausgegangen, daß zur Erfassung der MR-Daten auf einer einzigen Spirale auch nur eine einzige Anregung durch einen oder mehrere Hochfrequenzimpulse und ein anschließendes Auslesen der MR-Daten erforderlich ist. Es ist jedoch auch möglich, eine Spirale mittels mehrerer aufeinanderfolgender Anregungs- und Auslesezyklen zu durchlaufen. Dies hat den Vorteil, daß auch ein Teil der höheren Ortsfrequenzen ohne den störenden Einfluß der Inhomogenität des vom Magneten 1 (Fig. 1) erzeugten Haupt-Magnetfeldes gemessen werden kann. - Weiter sei erwähnt, daß auch andere zeitliche Abhängigkeiten als die in den Gleichungen (1) und (2) angegebenen möglich sind, z.B. solche, bei denen keine konstante Winkelgeschwindigkeit vorliegt

Bei den bisherigen Ausführungsbeispielen wurde davon ausgegangen, daß die Kernmagnetisierungsverteilung lediglich in einem zweidimensionalen ebenen Bereich - z.B. der x,y-Ebene - ermittelt werden sollte. Die Erfindung eignet sich aber auch für die dreidimensionale Bestimmung der Kernmagnetisierungsverteilung. Gerade für eine derartige dreidimensionale Bestimmung der Kernmagnetisierung ist eine Reduzierung der MR-Daten wichtig, damit die für die Gewinnung der MR-Daten erforderliche Meßzeit nahezu halbiert werden kann. Hierfür gibt es eine Reihe von Möglichkeiten.

1. Nach einer ersten Möglichkeit werden die Gradienten-Magnetfelder zeitlich so variiert, daß die MR-Daten im dreidimensionalen k-Raum längs ebener archimedischer Spiralen erfaßt werden, von denen eine oder mehrere in jeweils einer von einer Anzahl von Ebenen liegen. Diese Ebenen schneiden sich in einer durch den Nullpunkt des k-Raumes verlaufenden Geraden, d.h. der Nullpunkt liegt im Zentrum jeder dieser Ebenen. Man kann daher den für die vollständige Erfassung des k-Raumes erforderlichen Datensatz dadurch reduzieren, daß man für jede dieser Ebenen MR-Daten auf einem unvollständigen Spiralmuster erfaßt und die fehlenden MR-Hilfsdaten für die höheren Ortsfrequenzen so ergänzt, wie für den zweidimensionalen Fall in Verbindung mit den Fig 3-5 erläutert.

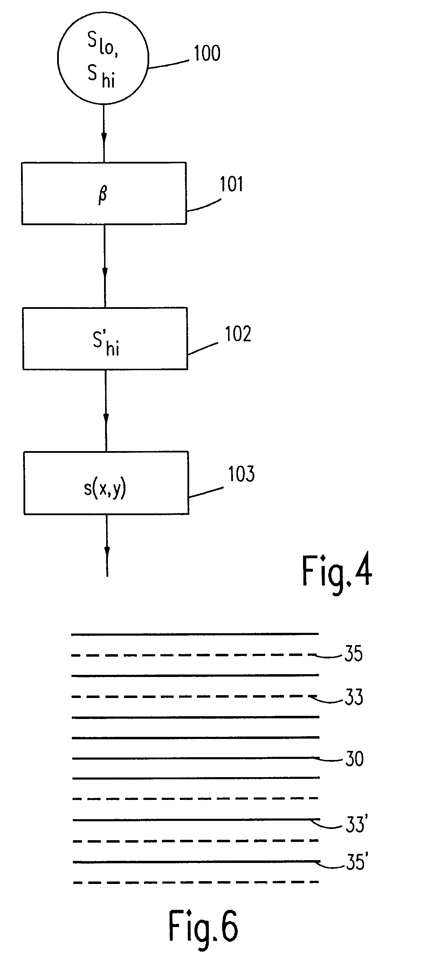

2. Man kann nach einer zweiten Möglichkeit den k-Raum längs paralleler Ebenen abtasten, von denen jede einzelne mit einen vollständigen Spiralmuster entsprechend Fig. 2a bedeckt sein kann. Es ist jedoch nicht erforderlich, die MR-Daten in sämtlichen dieser Ebenen zu messen. Dies ist in Fig. 6 dargestellt, die die Lage der Ebenen im k-Raum zeigt, wobei die Ebene 30 den Nullpunkt des k-Raums enthält. Die um diesen Nullpunkt herum liegenden Ebenen im k-Raum, d.h. die niedrigen Ortsfrequenzen müssen vollständig erfaßt werden. Für die weiter vom Nullpunkt entfernten Ebenen, die den höheren Ortsfrequenzen zugeordnet sind, ist dies nicht der Fall. Beispielsweise kann man, wie in Fig. 6 angedeutet, die dritte Ebene 33 und die fünfte Ebene 35 oberhalb der Mittelebene 30 weglassen und die zu diesen Ebenen gehörigen MR-Daten aus den MR-Daten der spiegelbildlich liegenden Ebenen 33' und 35' rekonstruieren, wobei man davon ausgeht, daß - von der Phasendrehung $\beta$ abgesehen - zueinander spiegelbildlich liegende Punkte (auf den Ebenen 33 bzw. 33' zueinander konjugiert komplexe MR-Daten aufweisen.

Es ist aber auch möglich, die Gradienten-Magnetfelder so zu variieren, daß die Ebenen außerhalb des Zentrums des k-Raumes mit einem unvollständigen Spiralmuster, z.B. gemäß Fig 3a, bedeckt sind, wenn das unvollständige Spiralmuster in einer dieser Ebenen - z.B. 35 - durch Spiegelung des Spiralmusters in der dazu spiegelbildlich liegenden Ebene (35') zu einem vollständigen Spiralmuster ergänzt werden kann.

Die Rekonstruktion aus dem auf diese Weise reduzierten MR-Datensatz kann dann analog zu dem in Fig. 4 erläuterten Verfahren erfolgen:
Es wird zunächst die Phasendrehung für die vollständig erfaßten MR-Daten ermittelt, die im k-Raum in der Nähe des Nullpunkts und symmetrisch zur Mittelebene 30 liegen (Block 101). Danach werden für die Ebenen (z.B. 33 und 35), die den hohen Ortsfrequenzen zugeordnet sind und für die keine MR-Daten erfaßt wurden aus den MR-Daten der dazu spiegelbildlich liegenden Ebenen (33' und 35') MR-Hilfsdaten abgeleitet, mit denen der unvollständige MR-Datensatz komplettiert wird (Block 102). Schließlich wird aus dem komplettierten Datensatz durch eine inverse Fourier-Transformation die dreidimensionale Kernmagnetisierungsverteilung s(x,y,z) im Untersuchungsbereich ermittelt.

3. Die beiden vorstehenden Möglichkeiten gehen von ebenen, d.h. zweidimmensionalen, Spiralen aus. Jedoch ist es auch möglich, die MR-Daten längs dreidimensionaler Spiralen erfassen, insbesondere solchen, die auf einem Kegelmantel liegen, dessen Spitze sich im Nullpukt des k-Raumes befindet. Der Begriff "Spirale" in Verbindung mit der Erfindung ist daher in diesem Sinne breit aufzufassen. Geht man davon aus, daß die Achse des Kegelmantels in der z-Richtung des k-Raumes verläuft, dann gelten für die auf dem Kegelmantel liegenden Spiralen die Gleichungen (1) und (2) und zusätzlich die Gleichung:

$$k_z = b|t|$$ (9)

wobei b eine Konstante ist. Der dafür erforderliche zeitliche Verlauf der Gradientenmagnetfelder $G_x$, $G_y$ und $G_z$ ergibt sich analog zu Gleichung (4) aus der zeilichen Ableitung von $k_x$, $k_y$ und $k_z$. $G_z$ ist dann also konstant.

Um einen dreidimensionalen Bereich abtasten zu können, ist eine Schar solcher mit Spiralen bedeckter Kegelmäntel erfoderlich, die dieselbe Kegelachse, aber unterschiedliche (positive und negative) Öffnungswinkel aufweisen und die auf einer Kugeloberfläche um den Nullpunkt des k-Raums enden. Analog zu dem zweidimmensionalen Fall kann außerhalb einer den niedrigen Ortsfrequenzen zugeordneten Kugel um den Nullpunkt des k-Raumes jeder zweite Kegelmantel - und die damit verbundene MR-Messung - entfallen, wenn der spiegelbildlich bezüglich des Nullpunktes liegende Kegelmantel beibehalten wird. Stattdessen können aber auch alle Kegelmäntel beibehalten und die darauf außerhalb der erwähnten Kugel an sich erforderlichen Spiralen reduziert werden, wenn auf dem spiegelbildlich liegenden Kegelmantel eine spiegelbildlich liegende Spirale existiert.

Die Rekonstruktion der Kernmagnetisierungsverteilung kann dann erfolgen, wie anhand der Fig 3-5 erläutert: Für die fehlenden Kegelmäntel bzw die fehlenden Spiralen werden MR-Hilfsdaten $S'_{hi}(-k)$ aus den MR-Daten $S_{hi}(k)$

abgeleitet ($k = ( k_x, k_y, k_z)$, die den spiegelbildlich liegenden Kegelmänteln zugeordnet sind. Der dadurch komplettierte MR-Datensatz wird einer inversen Fouriertransformation unterzogen.

**Patentansprüche**

1.  MR-Verfahren zur Bestimmung der räumlichen Verteilung der Kernmagnetisierung ($s(x,y)$) in einem Untersuchungsbereich mit folgenden Schritten:

    a) mindestens einmalige Anregung der Kernmagnetisierung in dem Untersuchungsbereich (2) durch wenigstens einen Hochfrequenzimpuls in Anwesenheit eines stationären homogenen Magnetfeldes;
    b) Auslesen der nach der Anregung entstehenden MR-Signale zur Erzeugung von MR-Daten, wobei während des Auslesens auf den Untersuchungsbereich Gradienten-Magnetfelder einwirken;
    c) Variation dieser Gradienten-Magnetfelder derart, daß die MR-Signale im Ortsfrequenzbereich entlang wenigstens einer Spirale (21) erfaßt werden, wobei in dem den niedrigen Ortsfrequenzen entsprechenden zentralen Teil (C) des Ortsfrequenzbereiches die Spiralen bzw. deren Windungen eine höhere Dichte haben als in dem übrigen Teil des Ortsfrequenzbereiches, und wobei die Spiralen im übrigen Teil des Ortsfrequenzbereiches zusammen mit ihren Spiegelbildern den übrigen Teil mit einer für die Rekonstruktion ausreichenden Dichte bedecken;
    d) Rekonstruktion der Kernmagnetisierungsverteilung für den Untersuchungsbereich aus den MR-Daten.

2.  MR-Verfahren nach Anspruch 1, d.g. daß die Anregung der Kernmagnetisierung und das Auslesen der MR-Signale p/2 mal wiederholt werden, wobei p eine gerade Zahl ist, und daß der zeitliche Verlauf der Gradienten-Magnetfelder ($G_x$, $G_y$) von Wiederholung zu Wiederholung so variiert wird,

    a) daß sich p gleiche, ebene Spiralen mit um 360°/p gegeneinander versetzten Startwinkeln ergeben, die sich von dem Rand des zentralen Teils (C) des Ortsfrequenzbereiches bis in dessen Zentrum erstrecken,
    b) daß eine Gruppe von p/2 Spiralen, die so gewählt ist, daß die Differenz der Startwinkel zweier Spiralen dieser Gruppe stets verschieden von 180° ist, sich über den Rand des zentralen Teils hinaus erstreckt,
    c) und daß nach einer Anregung eine Spirale (z.B. 21) dieser Gruppe und eine Spirale (20) mit demgegenüber um 180° versetztem Startwinkel durchlaufen werden.

3.  MR-Verfahren nach Anspruch 2, d.g, daß p/2 eine ungerade ganze Zahl ist, und daß die Gruppe jede zweite Spirale umfaßt.

4.  MR-Verfahren nach Anspruch 1, d.g. daß die Gradienten-Magnetfelder ($G_x$, $G_y$) so variiert werden, daß die daraus im Ortsfrequenzbereich entstehenden Spiralen sich über den zentralen Teil (C) hinaus fortsetzen, wobei ihre Steigung außerhalb des zentralen Teiles doppelt so groß ist wie innerhalb des zentralen Teiles.

5.  MR-Verfahren nach Anspruch 1, dadurch gekennzeichnet, daß die Spirale(n) jeweils in Teilstücken durch mehrere aufeinanderfolgende Anregungs- und Auslesezyklen durchlaufen werden.

6.  MR-Verfahren nach einem der vorhergehnden Ansprüche, d.g., daß MR-Hilfsdaten ($S'_{hi}$) für im Ortsfrequenzbereich außerhalb des zentralen Teils liegende Hilfspunkte ($-k_x, -k_y$) aus MR-Daten ($S_{hi}$) von Punkten ($k_x, k_y$) abgeleitet werden, die spiegelbildlich dazu auf einer Spirale liegen, und daß die Kernmagnetisierungsverteilung ($s(x,y)$) für den Untersuchungsbereich aus einem die MR-Daten ($S_{hi}$) und die MR-Hilfsdaten ($S'_{hi}$) umfassenden Datensatz rekonstruiert wird.

7.  MR-Verfahren nach Anspruch 1, d.g., daß zur dreidimensionalen Bestimmung der Kernmagnetisierungsverteilung in dem Untersuchungsbereich der zeitliche Verlauf der Gradienten-Magnetfelder so variiert wird, daß die MR-Signale im Ortsfrequenzbereich entlang von Spiralen erfaßt werden, die in zueinander parallelen Ebenen liegen.

8.  MR-Verfahren nach Anspruch 7, d.g., daß die Ebenen in einem zentralen Teil des dreidimensionalen Ortsfrequenzbereiches eine für eine vollständige Rekonstruktion ausreichenden Dichte haben, und daß die im übrigen Teil liegenden Ebenen und die Spiegelbilder dieser Ebenen zusammen eine Dichte haben, die der Dichte der Ebenen im zentralen Bereich entspricht.

9.  MR-Verfahren nach Anspruch 1, d.g., daß zur dreidimensionalen Bestimmung der Kernmagnetisierungsverteilung in dem Untersuchungsbereich der zeitliche Verlauf der Gradienten-Magnetfelder so variiert wird, daß die MR-Signale im Ortsfrequenzbereich entlang von Spiralen erfaßt werden, die in Schar von Ebenen liegen, die sich in einer durch den Nullpunkt des Ortsfrequenzbereichs verlaufenden Geraden schneiden

10. MR-Verfahren nach Anspruch 1, d.g., daß zur dreidimensionalen Bestimmung der Kernmagnetisierungsverteilung in dem Untersuchungsbereich der zeitliche Verlauf der Gradienten-Magnetfelder so variiert wird, daß die MR-Signale im Ortsfrequenzbereich entlang von Spiralen erfaßt werden, die auf Kegelmänteln mit gemeinsamer Kegelachse und mit unterschiedlichen Öffnungswinkeln liegen, wobei außerhalb eines zentralen Bereiches um den Nullpunkt des k-Raumes ein Teil der Kegelmäntel entfällt, derart die verbleibenden Kegelmäntel zusammen mit ihren Spiegelbildern bezüglich des Nullpunktes eine für die Rekonstruktion ausreichende Dichte aufweisen.

11. MR-Anordnung zu Durchführung des Verfahrens nach Anspruch 1 mit:

a) einem Magneten (1) zur Erzeugung eines stationären, homogenen Magnetfeldes im Untersuchungsbereich,
b) einer Hochfrequenzspulen-Anordnung (3) zum Senden von magnetischen Hochfrequenzimpulsen bzw zum Empfangen von MR-Signalen,
c) Gradientenspulen-Anordnungen (7,8,9) zur Erzeugung von in Richtung des stationären homogenen Magnetfeldes verlaufenden Gradienten-Magnetfeldern mit in drei zueinander senkrechten Richtungen verlaufenden Gradienten,
d) einem Empfänger (6) zum Umsetzen der MR-Signale in eine Folge digitaler MR-Daten,
e) einer Rekonstruktionseinheit (6) zur Rekonstruktion der Kernmagnetisierungsverteilung im Untersuchungsbereich aus den MR-Daten
f) einer Steuereinheit (11) zur Steuerung der Einheiten a) bis e), die den zeitlichen Verlauf der Ströme durch die Gradientenspulen-Anordnungen derart steuert, daß die MR-Signale im Ortsfrequenzbereich entlang wenigstens eines Spiralen erfaßt werden, wobei in dem den niedrigen Ortsfrequenzen entsprechenden zentralen Teil des Ortsfrequenzbereiches die Spiralen bzw. deren Windungen eine mindestens doppelt so große Dichte haben wie in dem übrigen Teil des Ortsfrequenzbereiches, und wobei die Spiralen im übrigen Teil des Ortsfrequenzbereiches zusammen mit ihren Spiegelbildern den übrigen Teil mit einer für die Rekonstruktion ausreichenden Dichte bedecken.

Fig.1

Fig.2a

Fig.2b

Fig.3a

Fig.3b

Fig.5a

Fig.5b

Fig.4

Fig.6

Europäisches Patentamt

## EUROPÄISCHER RECHERCHENBERICHT

Nummer der Anmeldung

EP 95 20 2083

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | PROCEEDINGS OF THE SOCIETY OF MAGNETIC RESONANCE IN MEDICINE, TWELFTH ANNUAL SCIENTIFIC MEETING, Bd.3, 14. August 1993, NEW YORK, NY, USA Seite 1261 D. SPIELMAN ET AL. 'VARIABLE-DENSITY SPIRALS FOR MR FLUOROSCOPY' * das ganze Dokument * | 1,11 | G01R33/561 |
| Y | --- | 5,7 | |
| X | PROCEEDINGS OF THE SOCIETY OF MAGNETIC RESONANCE IN MEDICINE, Bd.1, 14. August 1993, NEW YORK, NY, USA Seite 475 C.H. MEYER ET AL. 'SPIRAL FLUOROSCOPY' * das ganze Dokument * | 1,11 | |
| Y | --- | 5,7 | |
| A | MAGNETIC RESONANCE IN MEDICINE., Bd.28, Nr.2, Dezember 1992, DULUTH,MN US Seiten 202 – 213 C.H. MEYER ET AL. 'FAST SPIRAL CORONARY ARTERY IMAGING' * das ganze Dokument * --- | 1,5,7,11 | RECHERCHIERTE SACHGEBIETE (Int.Cl.6) G01R |
| A | MAGNETIC RESONANCE IN MEDICINE., Bd.31, Nr.5, Mai 1994, DULUTH,MN US Seiten 504 – 512 P.D. GATEHOUSE ET AL. 'REAL TIME BLOOD FLOW IMAGING BY SPIRAL SCAN PHASE VELOCITY MAPPING' * das ganze Dokument * --- | 1,5,7,11 | |

-/--

Der vorliegende Recherchenbericht wurde für alle Patentansprüche erstellt

| Recherchenort | Abschlußdatum der Recherche | Prüfer |
|---|---|---|
| DEN HAAG | 9. November 1995 | Horak, G |

EPO FORM 1503 03.82 (P04C03)

| ))) Europäisches Patentamt | EUROPÄISCHER RECHERCHENBERICHT | Nummer der Anmeldung EP 95 20 2083 |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| A | PROCEEDINGS OF THE SOCIETY OF MAGNETIC RESONANCE IN MEDICINE, Bd.3, 14. August 1993, NEW YORK, NY, USA Seite 1262 T.L. CHENEVERT ET AL. 'DYNAMIC 3D IMAGING AT HIGH TEMPORAL RESOLUTION VIA REDUCED K-SPACE SAMPLING' * das ganze Dokument * --- | 1,11 | |
| A | US-A-5 122 747 (S.J. RIEDERER ET AL.) * Spalte 2, Zeile 8 - Spalte 4, Zeile 17; Abbildungen 6,9 * --- | 1,5,7,11 | |
| A | WO-A-92 12439 (GENERAL ELECTRIC COMPANY) * Seite 5, Zeile 29 - Seite 7, Zeile 16 * * Seite 15, Zeile 13 - Seite 21, Zeile 30; Abbildungen 4,7A,7B * --- | 1,5,7,11 | |
| A,D | IEEE TRANSACTIONS ON MEDICAL IMAGING, Bd.5, Nr.1, März 1986, NEW YORK US Seiten 2 - 7 C.B. AHN ET AL. 'HIGH-SPEED SPIRAL-SCAN ECHO PLANAR NMR IMAGING - I' * das ganze Dokument * --- | 1,5,7,11 | RECHERCHIERTE SACHGEBIETE (Int.Cl.6) |
| A,P | WO-A-95 04946 (THE BOARD OF TRUSTEES OF THE LELAND STANFORD JUNIOR UNIVERSITY) * Seite 2, Zeile 35 - Seite 3, Zeile 32 * * Seite 5, Zeile 30 - Seite 10, Zeile 34; Abbildungen 5A,5B * ----- | 1,5,7,11 | |

Der vorliegende Recherchenbericht wurde für alle Patentansprüche erstellt

| Recherchenort | Abschlußdatum der Recherche | Prüfer |
|---|---|---|
| DEN HAAG | 9. November 1995 | Horak, G |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P04C03)